Europäisches Patentamt

**European Patent Office**

Office européen des brevets

(19)

(11) Publication number: **0 181 760**
A2

(12)

# EUROPEAN PATENT APPLICATION

(21) Application number: **85308022.4**

(22) Date of filing: **05.11.85**

(51) Int. Cl.⁴: **H 01 L 27/08**
**H 01 L 23/52, H 01 L 21/82**

(30) Priority: **05.11.84 US 668583**

(43) Date of publication of application:
**21.05.86 Bulletin 86/21**

(84) Designated Contracting States:
**DE FR GB**

(71) Applicant: **International Business Machines Corporation**
**Old Orchard Road**
**Armonk, N.Y. 10504(US)**

(72) Inventor: **Chappell, Barbara Alane**
**RFD Adele Court**
**Amawalk New York 10501(US)**

(72) Inventor: **Ning, Tak Hung**
**1720 Maxwell Court**
**Yorktown Heights New York 10598(US)**

(72) Inventor: **Terman, Lewis Madison**
**Twin Lakes Road**
**South Salem New York 10590(US)**

(74) Representative: **Hobbs, Francis John**
**IBM United Kingdom Patent Operations Hursley Park**
**Winchester, Hants, SO21 2JN(GB)**

(54) A device comprising a pair of CMOS FETs and a method of making it.

(57) All the gates and source/drain contacts in a CMOS device (1) are formed from polysilicon or polycide. Using two levels of polysilicon or polycide, the first level is used to simultaneously form the gate (10) of one (2) of the CMOS transistors and buried contacts (30, 31) to the source/drain regions (13, 14) of the other (3) CMOS transistor. The second level of polysilicon or polycide is then used to simultaneously form the gate (15) of the other (3) CMOS transistor and the buried contacts (28, 29) to the source/drain regions (8,9) of the first mentioned CMOS transistor. Because all the gates and contacts are polysilicon or polycide, it is possible to make interconnections between the gate on one of the devices and the source or drain of the other of the devices and between the gate on the other of the devices and the source/drain on said one of the devices simply by patterning the polysilicon or polycide layers.

EP 0 181 760 A2

./...

FIG.1

A DEVICE COMPRISING A PAIR OF CMOS FETS

AND A METHOD OF MAKING IT

This invention relates to a device comprising a pair of
Complementary Metal-Oxide-Semiconductor (CMOS) field effect transistors
(FETs) and a method of making it.

Because high density in the integrated circuit environment
contributes to speed of operation, efforts are being made continuously
to obtain more speed by packing individual switchable devices more
closely together.  One way to achieve this is to reduce or limit
interconnections between different portions of devices so that such
devices can be laid out with smaller and smaller areal dimensions.  As
will be seen from a consideration of the prior art discussed
hereinbelow, a number of different approaches have been used which
include forming both gates on and interconnection to a source/drain area
and forming polysilicon interconnections to adjacent diffusions of
different conductivity type.

US-A-4,443,811 discloses the formation of two gates and an
interconnection to a source/drain region from the same layer of
polysilicon in the CMOS environment.  The polysilicon interconnection is
connected to a source/drain region and a metallic layer interconnects
the source of one of the CMOS devices with the drain of the other of the
CMOS devices.  However, there is no connection shown at all to one of
the source/drain regions of the p-channel device.  At best, the
reference shows a single buried contact.

An article in the IBM Technical Disclosure Bulletin entitled
"Latch-Up Free, Double Gated, Enhancement-Type P-Channel Device For CMOS
With Enhanced Transconductance" by S. Ogura et al, Vol. 27, No. 1B, June
1984, page 722 also shows the gates for a pair of CMOS devices and a
buried contact being formed from the same layer of polycrystalline
silicon.  The source/drain contacts for each of the devices are formed from a refractory metal.  There is no indication that the gates of the devices are connected to the source/drain of either of the devices.

US-A-4,442,591, discloses a CMOS device wherein first and second levels of polycrystalline silicon are used.  The first level forms one plate of a capacitor which at one end makes a buried contact with the drain of an n-channel device.  The second level is used to form the gate of both devices and the other plate of the capacitor.  All other contacts to source/drain regions are metallic.  There is no hint or suggestion that a gate and such regions may be interconnected in any way.

An article entitled "Cross-Coupled Flip-Flop Transistors With Stacked Interconnection Lines" by H. H. Berger et al in the IBM Technical Disclosure Bulletin, Vol. 21, No. 12, May 1979, page 4886 shows a triple poly structure wherein three separate depositions of polycrystalline silicon are utilised to form cross-coupling for a bipolar flip-flop such that the collector of one device is connected to the base of the other and vice versa.  In an initial step, a layer of p+ polysilicon is deposited and delineated so that two portions are formed which contact p-type base regions of both bipolar devices.  A silicide is then formed on the surface of the p+ polysilicon regions.  In a subsequent step, a layer of n+ polysilicon is deposited and delineated so that it connects the n-type collector region of one of the bipolar devices to the p-type base region of the other of the bipolar devices via the silicide layer on the above mentioned p+ polysilicon region. After an insulating layer is deposited and delineated, a third layer of n+ polysilicon is deposited and delineated such that it contacts the n-type collector region of one of the bipolar devices to the p-type base region of the other of the bipolar devices.  To the extent that this reference requires a third polysilicon layer to complete the cross-coupling of a pair of bipolar devices, it differs from the present application in that each polysilicon layer of the reference makes only one contact with each device as opposed to the arrangement of the present application wherein each layer of polysilicon makes two contacts with one device and with the gate of the other device. In addition, none of the contacts are buried.

US-A-4,244,752 discloses a CMOS structure in FIGS. 1 and 14 wherein gates 19 and 25 and their interconnections are formed from a single layer of polycrystalline silicon. All of the source/drain regions are ion implanted and metal interconnections are made between a source/drain area 21 of one of the devices and a source/drain area 24 of the other of the pair of devices. It should be noted that only a single layer of polysilicon is used to form interconnected gates and that none of the contacts to source/drain regions are interconnected to these gates.

EP-A-21400 discloses a pair of complementary devices in FIG. 4 thereof wherein a source/drain region of one device is connected to a source/drain region of the other complementary device using two differently doped layers of polysilicon interconnected with a silicide region. In this figure, there is no interconnection between the gates of the complementary devices and any of the source/drain regions of these devices and there are no buried contacts in the CMOS structure.

US-A-4,333,099 discloses a pair of silicon-on-sapphire CMOS devices wherein a single layer of polysilicon is used to form an interconnection between a source/drain region of one of the devices and a source/drain region of the other of the devices. In this reference, the same polysilicon layer contacts a source/drain region on each of the devices and appears to simultaneously form the gates of both of the devices. There is no indication that the gates are interconnected in any way with source/drain regions of either of the CMOS devices.

According to one aspect of the invention, we provide a device comprising a pair of complementary metal-oxide-semiconductor field effect transistors, the device being characterised by including:-

a first level of conductive material forming a gate of one of said pair of complementary field effect transistors, buried contacts to the source/drain regions of the other of said pair of complementary field effect transistors and an interconnection between said gate and at least one of said buried contacts to said source/drain regions of said other of said pair of complementary field effect transistors, and

a second level of said conductive material forming another gate to said other of said pair of complementary field effect transistors, buried contacts to the source/drain regions of said one of said pair of complementary field effect transistors and an interconnection between said another gate and at least one of said buried contacts to said source/drain regions of said one of said pair of complementary field effect transistors.

According to another aspect of the invention, we provide a method of making a device comprising a pair of complementary metal-oxide-semiconductor field effect transistors, one of the pair of transistors being disposed in a semiconductor region of one conductivity type and the other of the pair of transistors being disposed in a semiconductor region of the opposite conductivity type, the method being characterised by:-

forming simultaneously from a first layer of conductive material a first gate for the one of said pair of transistors, a first pair of buried contacts for the other of said pair of transistors and an interconnection between said first gate and at least one of said first pair of buried contacts, and

forming simultaneously from a second layer of said conductive material a second gate for said other of the pair of transistors, a second pair of buried contacts for said one of the pair of transistors and an interconnection between said second gate and at least one of said second pair of buried contacts.

Using two levels of polysilicon, the first level is used to simultaneously form the gate of one of the CMOS devices and buried contacts to the source/drain regions of the other of the CMOS devices.
The second level of polysilicon is then used to simultaneously form the
gate of the other of the CMOS devices and the buried contacts to the
source/drain regions of the first mentioned of the CMOS devices.
Because all the gates and contacts are polysilicon or polycide, it is
possible to make interconnections between the gate on one of the devices
and the source or drain of the other of the devices and between the gate
on the other of the devices and the source/drain on said one of the
devices simply by patterning the polysilicon or polycide layers.  In
this way, metallisation which is normally used for such
gate-to-source/drain interconnection is eliminated and the resulting
CMOS device area is significantly less than that required when metal
interconnections are used.

A preferred method of fabrication broadly consists of depositing a
first polysilicon or polycide layer over one region of a semiconductor
substrate which has a thin oxide layer and over another substrate region
from which the thin oxide layer has been removed.  The first polysilicon
or polycide layer is covered with a chemically vapour deposited oxide or
other insulating layer.  Using lithography, the layers are patterned to
form buried contacts in an n-channel device region and an insulated gate
in a p-channel device region.  A layer of oxide is then deposited and
etched by reactive ion etching to make certain all gate sidewalls are
covered with oxide.

A gate insulator for the n-channel device is then formed between
the previously formed buried contacts.  To the extent that thin oxide
has formed on the exposed surface of the p-channel region, it is removed
and a layer of undoped polysilicon or polycide is deposited.  The second
layer is then ion implanted with a p-dopant where it is used to form
buried contacts for the p-channel device and with an n-type dopant where
it is used to form the gate of the n-channel device.  The second layer
is then patterned and etched.  The p- and n-type source/drain regions
are then formed by an out-diffusion step from the overlying polysilicon
regions which form part of the buried contacts.  Using the double-polysilicon layer approach, interconnections between a
source/drain of one device and the gate of another device may be made
simultaneously. This approach also eliminates the need for ion
implantation of source/drain regions since these regions may be
out-diffused forming a buried, ohmic contact with the overlying
polysilicon elements.  This approach avoids the problem of metal
penetration of shallow source/drain junctions.  To the extent that
metallic interconnections are reduced, significant density improvements
are achieved.

How the invention can be carried out will now be described by way
of example, with reference to the accompanying drawings, in which:-

FIG. 1 is a partially cut-away, cross-sectional, perspective view
of a pair of complementary field effect transistor devices having buried
contacts to the source/drain regions of each of the devices (certain
oxides like the gate oxides and the final passivation oxide have not
been shown for purposes of clarity);

FIG. 2 is a cross-sectional view of the devices of FIG. 1 at an
intermediate stage in the preferred fabrication process;

FIG. 3 is a cross-sectional view of the structure of FIG. 2 after
the polysilicon or polycide and CVD oxide layers have been subjected to
a photolithographic patterning and etching step to form the gate of the
p-channel device and the elements from which the buried contacts to the
n-channel device are formed;

FIG. 4 is a cross-sectional view of the structure of FIG. 3 after
the formation of the n-channel gate oxide and a second polysilicon or
polycide layer and oxide; and

FIG. 5 shows the the structure of FIG. 4 after a boron ion
implantation ensures that any gap between the region resulting from out-diffusion of p-dopant from the element which forms the source region of the p-channel device and the edge of the p-channel gate is filled.

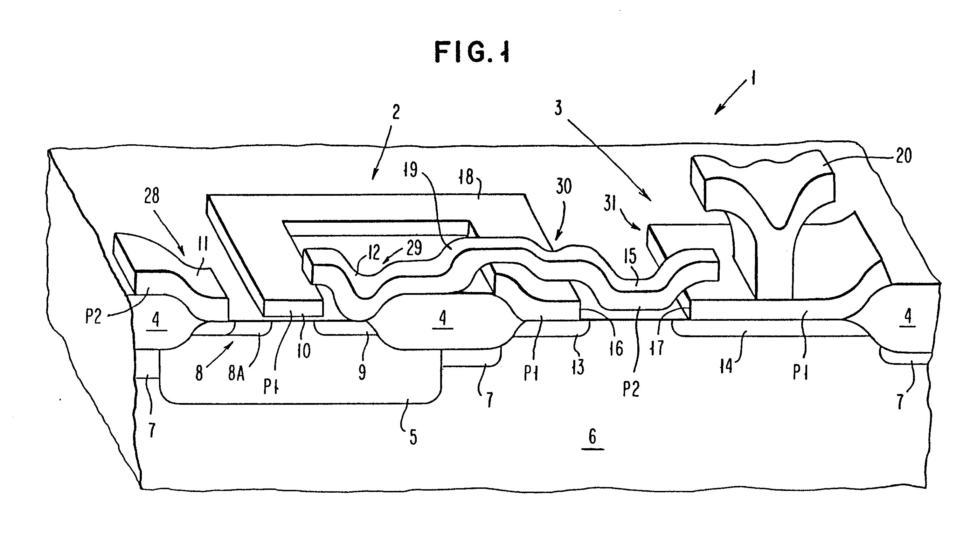

Referring to FIG. 1 there is shown a partially cut-away, cross-sectional perspective view of a Complementary Metal-Oxide Semiconductor (CMOS) structure 1 which includes a p-channel device 2 and an n-channel device 3 separated from each other by Recessed Oxide (ROX) regions 4. The p-channel device 2 is formed in an n-well 5 which is itself disposed in a substrate or epitaxial layer 6 of p-conductivity type. In addition to the electrical isolation provided by ROX regions 4, additional electrical isolation is provided by field implant regions 7 of high impurity doping level which are disposed beneath ROX regions 4. P-channel device 2 includes source/drain regions 8,9 both of which are of $p^+$-conductivity type and are disposed in n-well 5. Also included is a gate 10 of $n^+$ polycrystalline silicon or polycide disposed in insulated spaced relationship with n-well 5 and over the channel region between regions 8,9. Source/drain region 8 is electrically contacted by element 11 which is formed from reacted layers of undoped, as deposited, polycrystalline silicon and a silicide forming metal or polycrystalline silicon alone. An element 12 of similar material makes electrical contact with source/drain region 9. Ultimately, elements 11,12 are ion implanted to render them $p^+$-conductivity type. Similarly, n-channel device 3 includes source/drain regions 13,14 both of $n^+$-conductivity type disposed in substrate or epitaxial layer 6. Device 3 also includes a gate 15 which is disposed in insulated spaced relationship with substrate or epitaxial layer 6 and over the channel region between source/drain regions 13,14. Gate 15 is formed from reacted layers of undoped, as deposited, polycrystalline silicon and a silicide forming metal. Alternatively, gate 15 may be formed from undoped, as deposited, polycrystalline silicon. Gate 15 is ultimately rendered $n^+$-conductivity type by ion implantation. In FIG. 1, source/drain region 13 is electrically contacted by element 16 and source/drain region 14 is similarly contacted with element 17 both of which are formed from $n^+$ polycrystalline silicon (as deposited) or a reacted layer of $n^+$ polycrystalline silicon (as deposited) and a silicide forming metal. In FIG. 1, an interconnection 18 is shown interconnecting gate 10 of p-channel device 2 with element 16 of n-channel device 3. Interconnection 18, like gate 10 and element 16, is formed from $n^+$ polycrystalline silicon (as deposited) or reacted layers of polycrystalline silicon (as deposited) and a silicide forming metal. Gate 15 of n-channel device 3 is interconnected with element 12 of p-channel device 2 by means of interconnection 19. As will be seen hereinafter in the discussion of the fabrication process for device 1 of FIG. 1, interconnection 19 is formed of reacted layers of polycrystalline silicon and a silicide forming metal portions of which have been ion implanted to ensure that elements 11 and 12 are of $p^+$-conductivity type and that gate 15 is of $n^+$-conductivity type. As will also be seen hereinafter in the discussion that follows, interconnection 18 is formed at the same time as gate 10 and elements 16,17. Similarly, interconnection 19 is formed at the same time as gate 15 of n-channel device 3 and elements 11,12 of p-channel device 2. Metal contact 20 shown connected to element 17 of n-channel device 3 is representative of similar contacts which are normally applied to gates and buried contacts of CMOS devices to apply desired voltages to devices 2,3 and to propagate electrical signals.

Consideration of the CMOS structure 1 of FIG. 1 shows that gate 10 of p-channel device 2, elements 16,17 of n-channel device 3 and interconnection 18 are all formed from the same level of polycrystalline silicon or polycide. This is indicated in FIG. 1 by the designation P1 on these elements. Similarly, gate 15 of n-channel device 3, elements 11,12 of p-channel device 2 and interconnection 19 are all formed from a second level of polycrystalline silicon or polycide. This is indicated by the designation P2 shown on these elements in FIG. 1. As indicated hereinabove, with buried contacts for both p-channel device 2 and n-channel device 3, the usual problem of metal penetration of the shallow source/drain junctions is completely avoided. Further, as will be discussed in detail in what follows, the process for fabricating structure 1 permits cross-connections between source/drain and gate of p-channel device 2 and n-channel device 3 to be made using polysilicon or polycide layers instead of metal. This results in significant density improvement in CMOS memory applications.

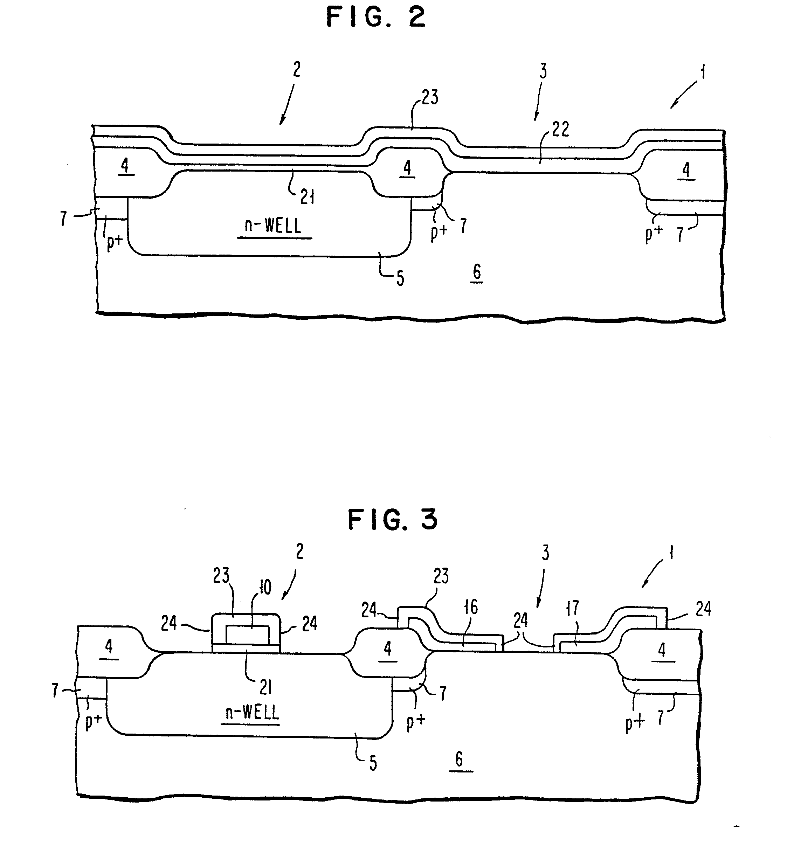

Referring to FIG. 2, there is shown a cross- sectional view of the structure 1 of FIG. 1 at an intermediate stage in its fabrication. In FIG. 2, spaced-apart recessed oxide regions 4 bound a pair of regions in which p-channel device 2 and n-channel device 3 will be formed. FIG. 2 shows n-well 5 and isolation regions 7. A gate oxide 21 is shown formed over n-well 5 and layers of $n^+$ polysilicon or polycide 22 and a Chemically Vapor Deposited (CVD) oxide layer 23 are shown formed on the surface of device 1.

Using a first mask, n-well 5 is formed by ion implantation. Then, using a second mask, ROX regions 4 and isolation regions 7 are formed by thermal oxidation and ion implantation steps, respectively. A detailed fabrication process used in forming ROX regions 4 and isolation regions 7 is described in US-A-4,471,523. While the technique described in US-A-4,471,523 requires only two masking steps, it should be appreciated that other well formation and field implantation steps may also be followed even though they may require additional masking steps.

In FIG. 2, n-well 5 is formed by the implantation and/or diffusion of phosphorous ions into silicon substrate or epitaxial layer 6. Isolation or field implant regions 7 are formed using the implantation of a p-type dopant such as boron into substrate or epitaxial layer 6. ROX regions 4 are thermally grown layers of silicon dioxide which are formed by heating the entire structure in an oxygen ambient in a well-known manner using silicon nitride as oxidation barriers in a second masking step.

After ROX regions 4 are formed, the oxidation barriers are stripped and the regions of substrate or epitaxial layer 6 between ROX regions 4 are subjected to a thermal oxidation step to grow a thin oxide layer in these regions. The thermal oxidation is carried out in an oxygen ambient at a temperature of approximately 950°C for a time sufficient to form the thin oxide layer.  Then, using well-known photolithographic masking and etching steps, a third masking step is carried out which forms a resist mask over n-well 5.  The thin oxide layer over that portion of substrate or epitaxial layer 6 where n-channel device 3 is to be formed is removed by dip etching in buffered HF.

The resist mask is then stripped using a suitable solvent leaving a thin gate oxide layer 21 on the surface of substrate or epitaxial layer 6 over n-well 5.  Prior to the removal of the resist mask, an ion implantation may be carried out which adjusts the threshold of the yet to be formed n-channel device 3.  In a subsequent step after the removal of the resist mask, a layer 22 of $n^+$ polycrystalline silicon or polycide is deposited all over the structure.  If layer 22 is of polycrystalline silicon, it may be deposited by Low Pressure Chemical Vapor Deposition (LPCVD) by the decomposition of silane gas in a standard reactor at a temperature of 650°C and 133 Pascals (1 TORR) pressure.  If layer 22 is of polycide, it may be co-deposited by the decomposition of silane and tungsten hexafluoride at a temperature of 200°C and a pressure of 133 Pascals (1 TORR).  Each approach has particular benefits associated with it.  For example, from a channel-length control point of view, polysilicon is preferable since it can be etched with tighter tolerances than the polycide.  The latter, however, has much lower resistance than the polysilicon.  After the deposition of layer 22, a layer 23 of CVD oxide is deposited using LPCVD of silane and oxygen at a temperature of 430°C and a pressure of 133 Pascals (1 TORR).

Referring to FIG. 3 in a fourth masking step, using well-known photolithographic masking and etching steps, layers 22,23 are patterned and etched to form elements 16,17 which will ultimately form a part of buried contact structures to n-channel device 3 and gate 10 of p-channel device 2.  The resist mask is stripped using a suitable solvent and a layer of CVD oxide or other suitable insulator is deposited everywhere using the previously mentioned silane and oxygen reaction to form silicon dioxide.  The resulting layer is followed by a blanket reactive ion etch (RIE) of the oxide to form sidewalls 24 on gate 10 and elements 16,17 all of which have been formed from layer 22. Each of these elements is covered with portions of oxide layer 23. At this point in the fabrication of the CMOS structure 1, portions of the substrate are exposed over which elements for buried contacts for p-channel device 2 and a gate electrode for n-channel device 3 will be formed.

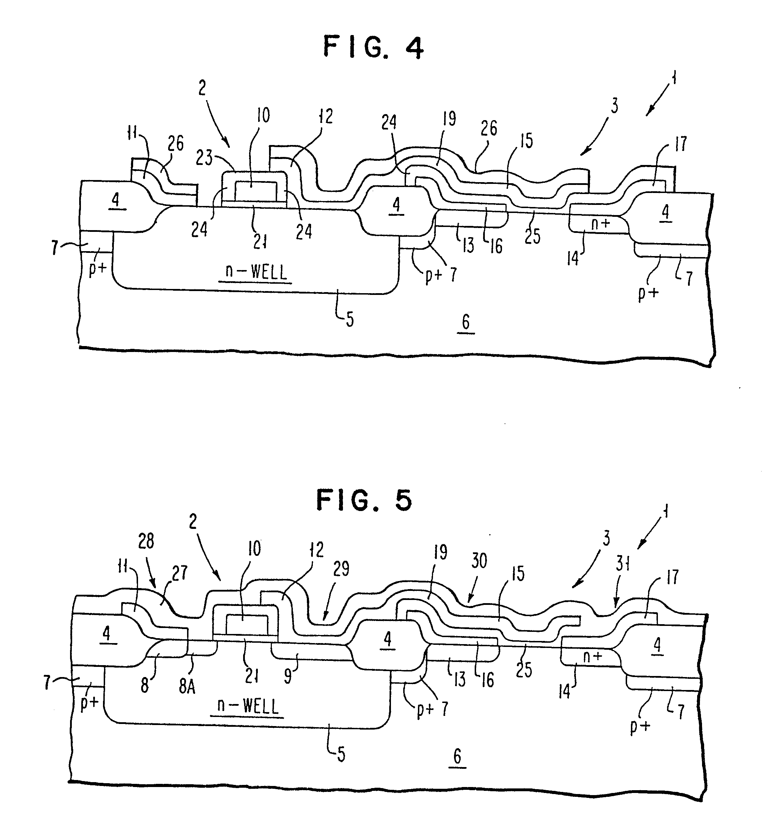

Referring to FIG. 4, a layer 25 of oxide which forms the gate oxide of device 3 is formed by thermal oxidation. Oxide also forms on the exposed surface regions of device 2 over portions of substrate 6 in which source/drain regions 8,9 are to be formed. At the same time, source/drain regions 13,14 of n-channel device 3 are formed by out-diffusion of dopants from elements 16,17. Also, a threshold tailoring implant of the channel of n-channel device 3 may be carried out, if desired. While not as specifically shown in FIG. 4, at this point, using a fifth masking step, contact holes may be formed using well-known photolithographic patterning and etching steps which form an interconnection region between portions of the elements which were formed from the first deposited polysilicon or polycide layer 22 and the subsequently deposited polysilicon or polycide layer from which gate 15 and elements 11,12 are to be formed. At the same time, portions of oxide layer 25 over portions of N-well 5 in which source/drain regions 8,9 are to be formed are removed. Alternatively, to form self-aligned contacts to regions 8,9, another mask may be used to remove thin oxide 25 from these regions. Once the contact holes have been opened, a layer of undoped polycide and a layer of oxide are formed all over the structure in the same manner as described in connection with layers 22,23. The polycide layer would be connected to some portion of the elements formed from the first polycide layer 22 at the contact openings just formed. To prevent interdiffusion of dopants between the two polycide layers, a conductive diffusion barrier layer, such as titanium nitride, may be sandwiched between the second polycide layer and the remaining portions of the first deposited polycide layer 22. The second polycide layer is undoped so that it may be doped with a p-type dopant where it is to be formed into elements 11,12 and doped with an n-type dopant where it is to be formed into gate 15 of n-channel device 3.

**0181760**

This involves the use of a sixth mask if a metal lift-off procedure is used after the first implantation. This approach involves the patterning of a resist to expose, for example, those portions of the second polycide layer which are to be formed into elements 11,12. Using the resist as a mask, boron is ion implanted to dope the desired portions of the second layer with the p-type dopant. At this point, a metal such as aluminium is deposited all over the top of the resist mask and the exposed portions of the second polycide layer. The resist mask is then subjected to a lift-off step which leaves aluminium on the previously implanted portions of the second polycide layer. In a second ion implantation step, the remaining portions of the second polycide layer are ion implanted with an n-type dopant such as phosphorous with the aluminium acting as an implant mask. The second polycide layer is then masked and patterned using a seventh mask. The second polycide layer and its overlying oxide are etched using suitable etchants. This step provides gate 15, interconnection 19 and elements 11,12 all of which are covered by oxide 26 and the structure of FIG. 4 results.

FIG. 4 shows interconnection 19 interconnecting gate 15 and element 12. While not specifically shown in the cross-sectional views of this and the previous FIGS., it should be appreciated that interconnection 18 shown in FIG. 1 is formed when polycide 22 is patterned. This interconnection and any other connections desired may be formed at the same time either of the polycide layers are patterned. In this way, interconnections can be made without using metals with their attendant masking, patterning and etching steps.

FIG. 5 shows the structure of FIG. 4 after boron is ion implanted to form region 8A to insure that source/ drain region 8 is extended up to the edge of gate 10 by filling any gap between the edge of buried contact 11 and gate 10. At this point, source/drain regions 8,9 are formed by the out-diffusion from elements 11,12. At the same time, a thin oxide is formed over the surface of substrate 6 above the gap. A layer of oxide 27 is then deposited by chemical vapour deposition and contact holes are formed therein using an eighth mask. After formation of contact openings and metallic contacts like contacts 20, the final structure of FIG. 1 results.

Until now, no mention has been made of the fact that all the contacts to substrate 6 are buried contacts. Thus, as shown in FIGS. 1,5, the buried contact structures are indicated by reference numbers 28, 29, 30, 31. Buried contact structure 28 includes source/drain region 8 and the interface portion of element 11 which overlaps source/drain region 8. Similarly, buried contact structure 29 includes source/drain region 9 and the interface portion of element 12 which overlaps it. Buried contact structures 30,31 include source/drain regions 13,14 and the interface portions of elements 16,17, respectively, which overlap them.

While the preferred embodiment is a CMOS structure which includes a p-channel device in an n-well and an n-channel device in a substrate of p-conductivity type, it should be appreciated that the process can be easily adapted to provide an n-channel device in a p-well and a p-channel device in a substrate of n-conductivity type. It should also be appreciated that the same process as described hereinabove may be invoked when twin-wells, one p-conductivity type and the other n-conductivity type, are used.

CLAIMS

1.   A device comprising a pair of complementary metal-oxide-semiconductor field effect transistors, the device being characterised by
including:-

   a first level of conductive material forming a gate (10) of one (2)
of said pair of complementary field effect transistors, buried contacts
(30, 31) to the source/drain regions (13, 14) of the other (3) of said
pair of complementary field effect transistors and an interconnection
(18) between said gate and at least one (30) of said buried contacts to
said source/drain regions of said other (3) of said pair of
complementary field effect transistors, and

   a second level of said conductive material forming another gate
(15) to said other (3) of said pair of complementary field effect
transistors, buried contacts (28, 29) to the source/drain regions (8, 9)
of said one of said pair of complementary field effect transistors and
an interconnection (19) between said another gate and at least one (29)
of said buried contacts to said source/drain regions of said one of said
pair of complementary field effect transistors.

2.   A device as claimed in Claim 1, wherein one pair of source/drain
regions of one of said pair of complementary field effect transistors
are disposed in a semiconductor substrate of one conductivity type and
the other pair of source/drain regions of the other of said pair of
complementary field effect transistors are disposed in a well of second
conductivity type which is disposed in said substrate.

3.   A device as claimed in Claim 1or Claim 2, wherein said conductive
material is polycrystalline silicon doped with a dopant to a level
sufficient to render said polysilicon conductive.

4.   A device as claimed in claim 3, wherein each of said source/drain regions are formed from dopants out-diffused from said polycrystalline silicon.

5.   A device as claimed in Claim 1 or Claim 2, wherein said conductive material is polycrystalline silicon doped with a dopant to a level sufficient to render said polysilicon conductive and a silicide forming metal reacted to form a polycide.

6.   A device as claimed in to Claim 5 wherein each of said source/drain regions are formed from dopants out-diffused from unreacted portions of said polycrystalline silicon of said polycide.

7.   A device as claimed in any preceding claim, wherein said buried contacts are ohmic contacts to said source/drain regions.

8.   A method of making a device comprising a pair of complementary metal-oxide-semiconductor field effect transistors, one (2) of the pair of transistors being disposed in a semiconductor region of one conductivity type and the other (3) of the pair of transistors being disposed in a semiconductor region of the opposite conductivity type, the method being characterised by:-

    forming simultaneously from a first layer of conductive material a first gate (10) for the one of said pair of transistors, a first pair (30, 31) of buried contacts for the other of said pair of transistors and an interconnection (18) between said first gate and at least one of said first pair of buried contacts, and

    forming simultaneously from a second layer of said conductive material a second gate (15) for said other of the pair of transistors, a second pair (28, 29) of buried contacts for said one of the pair of transistors and an interconnection (19) between said second gate and at least one of said second pair of buried contacts.

9.   A method as claimed in Claim 8, wherein the forming of the first gate, the first pair of buried contacts and the interconnection between the first gate and at least one of the first pair of buried contacts includes the steps of:

growing a thin oxide layer over said semiconductor regions,

removing said thin oxide layer from one of said semiconductor regions,

depositing said first layer of conductive material on at least said one of said semiconductor regions and on the remainder of said thin oxide layer,

depositing a layer of silicon dioxide on said first layer of conductive material, and,

patterning said layer of silicon dioxide, said thin oxide layer and said first layer of conductive material to form said first gate in insulated, spaced relationship to the other of said semiconductor regions, at least a portion of said first pair of buried contacts for said one of said semiconductor regions and said interconnection between said first gate and at least one of said at least a portion of said first pair of buried contacts.

10.   A method as claimed in claim 8 or claim 9, wherein the forming of the second gate and the second pair of buried contacts and the interconnection includes the steps of:

insulating the sidewalls of said first gate, said first pair of buried contacts and any said interconnection between them, and exposing the surfaces of said semiconductor regions adjacent said first gate and between said first pair of buried contacts,

growing another thin oxide layer between said first pair of buried contacts,

depositing said second layer of conductive material on at least said another thin oxide layer and on said exposed semiconductor regions adjacent said first gate, and

patterning said second layer of conductive material to form said second gate in insulated, spaced relationship to said semiconductor region between said first pair of buried contacts, said second pair of buried contacts for said exposed surfaces of said semiconductor region adjacent said first gate and said interconnection between said second gate and at least one of said second pair of buried contacts.

11. A method as claimed in any of claims 8 to 10, wherein said first and second layers of conductive material are comprised of doped polycrystalline silicon.

12. A method as claimed in any of claims 8 to 10, wherein said first and second layers of conductive material are comprised of a polycide formed from reacted doped polycrystalline silicon and a silicide forming metal.

13. A method as claimed in any of claims 8 to 10, wherein said buried contacts include diffused regions of conductivity type opposite to the conductivity type of said semiconductor regions in which they are formed and overlying regions of polycrystalline silicon or polycide having the same conductivity type as said diffused regions and said overlying regions forming ohmic contacts.

14. A method as claimed in claim 9, wherein the step of depositing said first layer of conductive material includes the step of depositing a layer of doped polycrystalline silicon on said at least said one of said semiconductor regions and on the remainder of said thin oxide layer.

15. A method as claimed in claim 9, wherein the step of depositing said first layer of conductive material includes the steps of depositing a layer of doped polycrystalline silicon on said at least said one of said semiconductor regions and on the remainder of said thin oxide layer, depositing a layer of a silicide forming metal on said layer of doped polycrystalline silicon and reacting said layer of doped polycrystalline silicon and said silicide forming metal to form a polycide.

16. A method as claimed in claim 14 or claim 15, further including the step of heating said layer of doped polycrystalline silicon after patterning to out-diffuse dopant into said at least one of said semiconductor regions to form source/drain regions therein and buried ohmic contacts to said source/drain regions.

17. A method as claimed in claim 10, wherein the step of depositing said second layer of conductive material includes the step of depositing a layer of polycrystalline silicon on at least said another thin oxide layer and on said exposed semiconductor regions adjacent said first gate.

18. A method as claimed in claim 10, wherein the step of depositing said second layer of conductive material includes the steps of depositing a layer of polycrystalline silicon on at least said another thin oxide layer and on said exposed semiconductor regions adjacent said first gate, depositing a layer of a silicide forming metal on said layer of polycrystalline silicon and reacting said layers of polycrystalline silicon and said silicide forming metal to form a polycide.

19. A method as claimed in claim 17 or claim 18, further including the steps of:

ion implanting dopants of opposite conductivity type into different portions of said second layer of conductive material prior to patterning, and,

heating said second layer of conductive material after patterning to out-diffuse one of said dopants into said exposed surfaces of said semiconductor regions adjacent said first gate to form source/drain regions and buried contacts to said source/drain regions.

20. A method as claimed in any of claims 8 to 19, wherein said semiconductor region of first conductivity type is a substrate of semiconductor material and said semiconductor region of second conductivity type is a well disposed in said substrate.

# FIG.1

# FIG. 2

# FIG. 3

0181760

# FIG. 4

# FIG. 5